# EUROPEAN PATENT APPLICATION

(11) **EP 4 730 115 A2**
(43) Date of publication of application: **22.04.2026**
(21) Application number: 26155807.6
(22) Date of filing: 02.02.2026
(51) Int. Cl.: G06F 9/30, G06F 9/38

(54) **COMPUTATION CIRCUIT, DATA PROCESSING METHOD, STORAGE MEDIUM AND ELECTRONIC DEVICE**

(30) Priority: 16.06.2025 CN 202510806353
(71) Applicant: Beijing Horizon Information Technology Co., Ltd., Beijing 100094 (CN)
(72) Inventor: DING, Jinnan, Beijing, 100094 (CN)
(74) Representative: Müller-Boré & Partner Patentanwälte PartG mbB

(57) **Abstract**

Disclosed are a computation circuit, a data processing method, a storage medium and an electronic device. The computation circuit comprises: an instruction processing sub-circuit configured to acquire (610) an atomic instruction, and cache (620) the atomic instruction corresponding to the same target operation address in the same target queue; a computation sub-circuit configured to acquire (630) raw data in a memory corresponding to the target operation address, a computation type indicated by each atomic instruction in the target queue, and an ordering attribute of each atomic instruction in the target queue; generate (640) target computation result data based on the raw data, the computation type and the ordering attribute; update (650) the raw data corresponding to the target operation address to the target computation result data. Embodiments of the present disclosure may enhance the execution efficiency of the atomic instructions.

## Description

### FIELD

The present disclosure relates to the chip technology, and particularly to a computation circuit, a data processing method, a storage medium and an electronic device.

### BACKGROUND

Atomic instructions are a type of special instructions provided by a computer architecture to ensure the indivisibility of operations, i.e., an operation is either fully executed or not executed at all.

It is to be appreciated that if there are a plurality of atomic instructions to be executed, they are typically executed in a serial manner, which results in low execution efficiency. Therefore, how to improve the execution efficiency of the atomic instructions is a noteworthy technical problem for those skilled in the art.

### SUMMARY

In order to solve the above technical problems, the present disclosure provides a computation circuit, a data processing method, a storage medium, and an electronic device.

According to one aspect of embodiments of the present disclosure, there is provided a computation circuit, comprising:
an instruction processing sub-circuit configured to acquire an atomic instruction, and cache the atomic instruction corresponding to the same target operation address in the same target queue;
a computation sub-circuit configured to acquire raw data in a memory corresponding to the target operation address, a computation type indicated by each atomic instruction in the target queue, and an ordering attribute of each atomic instruction in the target queue; generate target computation result data based on the raw data, the computation type and the ordering attribute; update the raw data corresponding to the target operation address to the target computation result data.

According to another aspect of embodiments of the present disclosure, there is provided a data processing method, comprising:
acquiring an atomic instruction;
caching the atomic instruction corresponding to the same target operation address in the same target queue;
acquiring raw data in a memory corresponding to the target operation address, a computation type indicated by each atomic instruction in the target queue, and an ordering attribute of each atomic instruction in the target queue;
generating target computation result data based on the raw data, the computation type and the ordering attribute;
updating the raw data corresponding to the target operation address to the target computation result data.

According to a further aspect of embodiments of the present disclosure, there is provided a computer readable storage medium storing a computer program which is executed by a processor to perform the data processing method.

According to a further aspect of embodiments of the present disclosure, there is provided an electronic device, comprising:
a processor;
a memory for storing instructions executable by the processor;
the processor is configured to read the executable instructions from the memory and execute the instructions to implement the data processing method described above.

According to yet another aspect of embodiments of the present disclosure, there is provided a computer program product which, when instructions in the computer program product are executed by a processor, performs the above-described data processing method.

According to the computation circuit, the data processing method, the storage medium, the electronic device and the program product provided by the above embodiments of the present disclosure, the instruction processing sub-circuit may cache the obtained atomic instructions according to a caching rule that atomic instructions corresponding to the same target operation address are cached in the same target queue. Through one read operation, the computation sub-circuit may acquire the raw data in the memory corresponding to the target operation address. Based on the raw data, the computation type indicated by each atomic instruction in the target queue, and the ordering attribute of each atomic instruction in the target queue, the computation sub-circuit may sequentially perform computation on the computation type indicated by each atomic instruction in the target queue on the basis of the raw data to generate the target computation result data. Through one write operation, the computation sub-circuit may update the data stored in the address space corresponding to the target operation address in the memory from the raw data to the target computation result data, thereby completing the execution of each atomic instruction in the target queue. It can be seen that in the embodiments of the present disclosure, in the case of caching atomic instructions according to the above caching rule, the execution of each atomic instruction in the target queue may be completed by acquiring the raw data in the memory through one read operation first, and then consecutively performing the modify operation several times for each atomic instruction in the target queue to obtain the target computation result data, and then updating the raw data in the memory to the target computation result data through one write operation, without need to sequentially perform the read operation, the modify operation and the write operation for each atomic instruction, thereby substantially reducing the number of times of execution of the read operation and the number of times of execution of the write operation, and thereby effectively improving the execution efficiency of the atomic instructions.

### BRIEF DESCRIPTION OF THE DRAWINGS

FIG. 1 is a schematic structural diagram of a computation circuit according to some exemplary embodiments of the present disclosure.
FIG. 2 is a schematic structural diagram of a computation sub-circuit in a computation circuit according to some exemplary embodiments of the present disclosure.
FIG. 3 is a second schematic structural diagram of a computation circuit according to some exemplary embodiments of the present disclosure.
FIG. 4 is a second schematic structural diagram of a computation sub-circuit in a computation circuit according to some exemplary embodiments of the present disclosure.
FIG. 5 is a third schematic structural diagram of a computation circuit according to some exemplary embodiments of the present disclosure.
FIG. 6 is a flow chart of a data processing method according to some exemplary embodiments of the present disclosure.
FIG. 7 is a second flow chart of a data processing method according to some exemplary embodiments of the present disclosure.
FIG. 8 is a third flow chart of a data processing method according to some exemplary embodiments of the present disclosure.
FIG. 9 is a fourth flow chart of a data processing method according to some exemplary embodiments of the present disclosure.
FIG. 10 is a fifth flow chart of a data processing method according to some exemplary embodiments of the present disclosure.
FIG. 11 is a sixth flow chart of a data processing method according to some exemplary embodiments of the present disclosure.
FIG. 12 is a seventh flow chart of a data processing method according to some exemplary embodiments of the present disclosure.
FIG. 13 is an eighth flow chart of a data processing method according to some exemplary embodiments of the present disclosure.
FIG. 14 is a block diagram of an electronic device according to some exemplary embodiments of the present disclosure.

### DETAILED DESCRIPTION OF EMBODIMENTS

To illustrate the present disclosure, exemplary embodiments according to the present disclosure will be described in detail with reference to the accompanying drawings. Obviously, the described embodiments are merely part of embodiments, rather than all embodiments of the present disclosure. It should be appreciated that the present disclosure is not limited by the exemplary embodiments.

It should be noted that unless otherwise specified, the scope of the present disclosure is not limited by relative arrangement, numeric expressions, and numerical values of components and steps described in these embodiments.

### Application Overview

At present, chips are used more and more widely. For example, in the field of driving technology, intelligent driving chips, smart cockpit chips, etc. are used more and more widely.

In general, a chip may comprise a computation circuit that may be used to execute an atomic instruction. The atomic instruction is usually executed in three steps, namely, reading, modifying and writing, i.e., the computation circuit may first read data from a memory, then perform computation on the read data, and then write the data resulting from the computation into the memory.

During the implementation of the present disclosure, the Inventor discovers that if there are a plurality of atomic instructions to be executed, they are typically executed in a serial manner, i.e., a read operation, a modify operation and a write operation are sequentially first performed for a first atomic instruction, then the read operation, the modify operation and the write operation are sequentially performed for a second atomic instruction, then the read operation, the modify operation and the write operation are sequentially performed for a third atomic instruction, and so on so forth, until the read operation, the modify operation and the write operation are sequentially performed for the last atomic instruction. Since the plurality of atomic instructions are executed in the serial manner, the execution efficiency is low and actual demands are hard to satisfy, it is necessary to take some measures to improve the execution efficiency of atomic instructions.

### Example System

In embodiments of the present disclosure, several atomic instructions corresponding to the same operation address may be determined. Next, raw data corresponding to the operation address may be read out from the memory by one read operation firstly, and then several modify operations are consecutively performed on the basis of the raw data to generate target computation result data, and then the raw data in the memory is updated to the target computation result data by one write operation, and so far, these atomic instructions all have been executed It is apparent that in the embodiments of the present disclosure, the read operation, the modify operation and the write operation needn't be performed successively for each atomic instruction, which can substantially reduce the number of times of execution of the read operation and the number of times of execution of the write operation, and thereby effectively improve the execution efficiency of the atomic instructions.

### Example Circuit

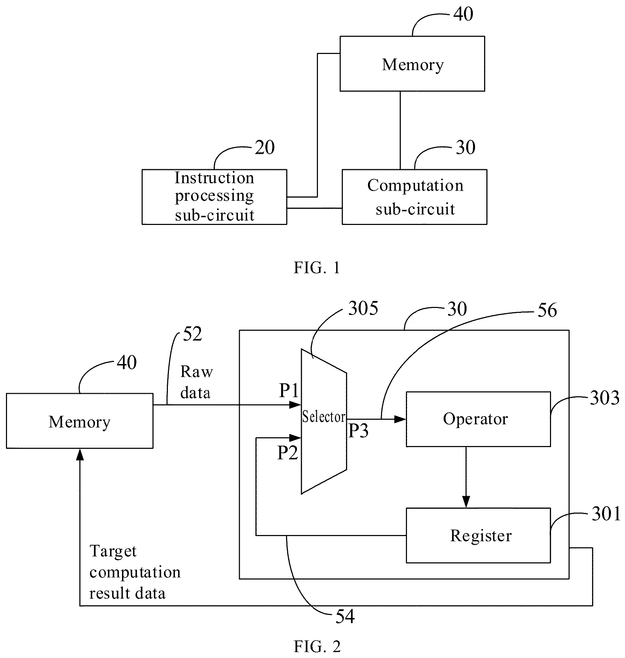

FIG. 1 is a schematic structural diagram of a computation circuit according to some exemplary embodiments of the present disclosure. As shown in FIG. 1, the computation circuit may comprise:
an instruction processing sub-circuit 20 configured to acquire atomic instructions, and cache atomic instructions corresponding to the same target operation address in the same target queue;
a computation sub-circuit 30 configured to acquire raw data corresponding to the target operation address from a memory 40, computation types indicated by the atomic instructions in the target queue, and ordering attributes of the atomic instructions in the target queue; generate target computation result data based on the raw data, the computation types and the ordering attributes; update the raw data corresponding to the target operation address to the target computation result data.

Optionally, the instruction processing sub-circuit 20 may be a circuit for acquiring and caching the atomic instructions. The instruction processing sub-circuit 20 may receive atomic instructions from a Central Processing Unit (CPU), a Graphics Processing Unit (GPU), a Digital Signal Processor (DSP), etc. The number of atomic instructions received by the instruction processing sub-circuit 20 may be plural, for example, M, where M may be an integer greater than or equal to 2. Each of the M atomic instructions may carry an operation address, and the operation address carried by any atomic instruction may be understood as an address which is indicated by the atomic instruction and needs an operation, and the operation address carried by any atomic instruction may be taken as the operation address corresponding to the atomic instruction. The instruction processing sub-circuit 20 may comprise a first cache space, and the instruction processing sub-circuit 20 may cache the M atomic instructions in a queue manner in the first cache space based on the operation addresses corresponding to the M atomic instructions respectively, so that the atomic instructions corresponding to the same target operation address are cached in the same target queue.

In an optional example, the M atomic instructions are 10 atomic instructions, i.e., atomic instruction D1, atomic instruction D2, atomic instruction D3 . . . atomic instruction D9, and atomic instruction D10, respectively, wherein the operation addresses corresponding to the atomic instructions D1 through D3 all are operation address A1, the operation addresses corresponding to the atomic instructions D4 through D6 all are operation address A2, and the operation addresses corresponding to the atomic instructions D7 through D10 all are operation address A3. Obviously, the atomic instructions D1 through D3 correspond to the same operation address (i.e., the operation address A1), the atomic instructions D4 through D6 correspond to the same operation address (i.e., the operation address A2), and the atomic instructions D7 through D10 correspond to the same operation address (i.e., the operation address A3). Then, the instruction processing sub-circuit 20 may cache the atomic instructions D1 through D3 in the same queue, for example, in a queue C1; the instruction processing sub-circuit 20 may further cache the atomic instructions D4 through D6 in the same queue, for example, in a queue C2; the instruction processing sub-circuit 20 may further cache the atomic instructions D7 through D10 in the same queue, such as in a queue C3. The operation address A1, the operation address A2 and the operation address A3 may respectively serve as a target operation address, and the queue C1, the queue C2 and the queue C3 may respectively serve as a target queue; the operation address A1 corresponds to the queue C1; the operation address A2 corresponds to the queue C2; the operation address A3 corresponds to the queue C3.

As known from the above example, the numbers of target operation addresses and target queues may both be plural. For ease of understanding, the following description will mainly focus on the relevant processing of a single target operation address and a corresponding target queue.

Optionally, the memory 40 may be a circuit for storing data. The memory 40 may include, but not limited to, a Double Data Rate Synchronous Dynamic Random Access Memory (DDR), a Static Random Access Memory (SRAM), a register file, etc.

Optionally, the computation sub-circuit 30 may be a circuit for executing the atomic instructions. Embodiments of the present disclosure may employ an architecture where the memory 40 is separate from the computation sub-circuit 30. The computation sub-circuit 30 may be electrically connected to the instruction processing sub-circuit 20, and the computation sub-circuit 30 may also be electrically connected to the memory 40. The computation sub-circuit 30 may acquire at least the following three items for executing the atomic instructions in the target queue: (a) raw data in the memory 40 corresponding to the target operation address; (b) a computation type indicated by each atomic instruction in the target queue; (c) an ordering attribute of each atomic instruction in the target queue.

In some optional implementations of the present disclosure, the instruction processing sub-circuit 20 may read the memory 40 to acquire data at the target operation address in the memory 40, wherein the data may serve as the raw data corresponding to the target operation address. The raw data may include, but not limited to, image data, feature map data etc. As an example, the computation circuit may be designed in an intelligent driving chip, and a camera may be provided on a vehicle mounted with the intelligent driving chip; the image data included in the raw data may be at least part of environmental image data captured by the camera; the feature map data included in the raw data may be at least part of feature map data obtained by performing a predetermined operation on the environmental image data captured by the camera. Here, the predetermined operation may include, but not limited to a tensor operation, a vector operation, etc. The tensor operation may comprise a convolution operation, including, for example, a two-dimensional convolution operation, a three-dimensional convolution operation, etc. The vector operation may comprise a point-to-point element-by-element operation including, for example, a point-to-point element-by-element multiplication operation, a point-to-point element-by-element addition operation, etc.

In some optional implementations of the present disclosure, each of the M atomic instructions may carry a computation type, and the computation sub-circuit 30 may determine the computation type carried by any of the atomic instructions as the computation type indicated by the atomic instruction. The computation type may include, but not limited to, an atomic addition/subtraction type, an atomic increment/decrement type, an atomic multiplication type, an atomic maximum/minimum value type, etc.

In some optional implementations of the present disclosure, the atomic instructions in the target queue may be sequentially added to the target queue, and the computation sub-circuit 30 may determine the ordering attributes of the atomic instructions in the target queue in an order of addition of the atomic instructions to the target queue. For example, for an atomic instruction first added to the target queue, the computation sub-circuit 30 may determine that the ordering attribute of the atomic instruction is a head-of-queue attribute, i.e., the atomic instruction serves as a head-of-queue element of the target queue. As another example, for an ending (i.e., the last) atomic instruction added to the target queue, the computation sub-circuit 30 may determine that the ordering attribute of the atomic instruction is a tail-of-queue attribute, i.e., the atomic instruction serves as a tail-of-queue element of the target queue. As another example, for an atomic instruction added to the target queue that is not an initial one and an ending one (i.e., neither the first one nor the last one), the computation sub-circuit 30 may determine that the ordering attribute of the atomic instruction is an in-the-queue attribute, i.e., the atomic instruction serves as an in-the-queue element of the target queue.

In some optional implementations of the present disclosure, based on the raw data, the computation type indicated by each atomic instruction in the target queue, and the ordering attribute of each atomic instruction in the target queue, the computation sub-circuit 30 may sequentially perform the computation on the computation type indicated by each atomic instruction in the target queue on the basis of the raw data to generate the target computation result data. As such, the target computation result data may also be understood as computation result data that can be obtained by consecutively performing the modify operation several times on each atomic instruction in the target queue on the basis of the raw data. The computation sub-circuit 30 may write the target computation result data into the address space in the memory 40 corresponding to the target operation address to update the data stored in the address space corresponding to the target operation address from the raw data to the target computation result data.

In embodiments of the present disclosure, the instruction processing sub-circuit 20 may cache the acquired atomic instructions according to a caching rule that atomic instructions corresponding to the same target operation address are cached in the same target queue. Through one read operation, the computation sub-circuit 30 may acquire the raw data in the memory 40 corresponding to the target operation address. Based on the raw data, the computation type indicated by each atomic instruction in the target queue, and the ordering attribute of each atomic instruction in the target queue, the computation sub-circuit 30 may sequentially perform computation on the computation type indicated by each atomic instruction in the target queue on the basis of the raw data to generate the target computation result data. Through one write operation, the computation sub-circuit 30 may update the data stored in the address space in the memory 40 corresponding to the target operation address from the raw data to the target computation result data, thereby completing the execution of each atomic instruction in the target queue. It can be seen that in the embodiments of the present disclosure, in the case of caching atomic instructions according to the above caching rule, the execution of each atomic instruction in the target queue may be completed by acquiring the raw data in the memory 40 through one read operation first, and then consecutively performing the modify operation several times for each atomic instruction in the target queue to obtain the target computation result data, and then updating the raw data in the memory 40 to the target computation result data through one write operation, without need to sequentially perform the read operation, the modify operation and the write operation for each atomic instruction, thereby substantially reducing the number of times of execution of the read operation and the number of times of execution of the write operation, and thereby effectively improving the execution efficiency of the atomic instructions.

In some optional examples, the computation sub-circuit 30 configured to generate the target computation result data based on the raw data, the computation type and the ordering attribute may comprise:
The computation sub-circuit 30 is configured to perform computation on the raw data based on the corresponding computation type for the atomic instruction in the target queue whose ordering attribute is the head-of-queue attribute, to generate and cache reference computation result data;

The computation sub-circuit 30 is configured to perform computation on the most recently-cached reference computation result data based on the corresponding computation type for the atomic instruction in the target queue whose ordering attribute is the in-the-queue attribute, to generate and cache new reference computation result data;
The computation sub-circuit 30 is configured to perform computation on the most recently-cached reference computation result data based on the corresponding computation type for the atomic instruction in the target queue whose ordering attribute is the tail-of-queue attribute, to generate the target computation result data.

Optionally, for the atomic instruction in the target queue whose ordering attribute is the head-of-queue attribute, the computation sub-circuit 30 may perform computation on the raw data based on the computation type indicated by the atomic instruction to generate the reference computation result data. For example, if the computation type indicated by the atomic instruction is an atomic addition type, the computation sub-circuit 30 may perform an atomic addition-type computation on the raw data to generate the reference computation result data. As another example, if the computation type indicated by the atomic instruction is an atomic multiplication type, the computation sub-circuit 30 may perform an atomic multiplication-type computation on the raw data to generate the reference computation result data. The computation sub-circuit 30 may comprise a second cache space, and the computation sub-circuit 30 may cache the reference computation result data in the second cache space.

Optionally, for the atomic instruction in the target queue whose ordering attribute is the in-the-queue attribute, the computation sub-circuit 30 may perform computation on the most recently-cached reference computation result data in the second cache space based on the computation type indicated by the atomic instruction, to generate new reference computation result data, and cache the new reference computation result data in the second cache space. As such, the most recently-cached reference computation result data in the second cache space mentioned in this paragraph might be the reference computation result data generated after the computation is performed on the raw data in the previous paragraph, or also might be the new reference computation result data generated after the computation is performed on the generated reference computation result data.

Optionally, for the atomic instructions in the target queue whose ordering attribute is the tail-of-queue attribute, the computation sub-circuit 30 may perform computation on the most recently-cached reference computation result data in the second cache space based on the computation type indicated by the atomic instruction, to generate new reference computation result data which may serve as the target computation result data.

In one example, with the queue C3 in the preceding text as the target queue, the target queue comprises four atomic instructions, i.e., an atomic instruction D7, an atomic instruction D8, an atomic instruction D9, and an atomic instruction D10. In the target queue, the atomic instruction D7 may be located at the head of the queue, the atomic instruction D10 may be located at the tail of the queue, the atomic instruction D8 and atomic instruction D9 may be located between the head and tail of the queue, and the atomic instruction D8 and the atomic instruction D7 may be adjacent to each other. The computation type indicated by the atomic instruction D7 may be a computation type R1; the computation type indicated by the atomic instruction D8 may be a computation type R2; the computation type indicated by the atomic instruction D9 may be a computation type R3; the computation type indicated by the atomic instruction D10 may be a computation type R4.

The computation sub-circuit 30 may consecutively perform the modify operation four times for each atomic instruction in the target queue on the basis of the raw data. For example, the computation sub-circuit 30 may first perform the modify operation for the atomic instruction D7, then perform the modify operation for the atomic instruction D8, then perform the modify operation for the atomic instruction D9, and finally perform the modify operation for the atomic instruction D10.

Since the atomic instruction D7 is located at the head of the queue, i.e., the ordering attribute of the atomic instruction D7 is the head-of-queue attribute, the computation sub-circuit 30, upon performing the modify operation for the atomic instruction D7, may perform computation on the raw data based on the computation type R1 to generate and cache reference computation result data S1.

Since the atomic instruction D8 is in the queue, i.e., the ordering attribute of the atomic instruction D8 is the in-the-queue attribute, and since the most recently-cached reference computation result data is the reference computation result data S1, the computation sub-circuit 30, upon performing the modify operation with respect to the atomic instruction D8, may perform computation on the reference computation result data S1 based on the computation type R2 to generate and cache reference computation result data S2.

Since the atomic instruction D9 is located in the queue, that is, the ordering attribute of the atomic instruction D9 is the in-the-queue attribute, and since the most recently-cached reference computation result data is the reference computation result data S2, the computation sub-circuit 30, upon performing the modify operation for the atomic instruction D9, may perform computation on the reference computation result data S2 based on the computation type R3 to generate and cache reference computation result data S3.

Since the atomic instruction D10 is located at the tail of the queue, that is, the ordering attribute of the atomic instruction D10 is the tail-of-queue attribute, and since the most recently-cached reference computation result data is the reference computation result data S3, the computation sub-circuit 30, upon performing the modify operation for the atomic instruction D10, may perform computation on the reference computation result data S3 based on the computation type R4 to generate the target computation result data.

In an embodiment of the present disclosure, based on the raw data, the computation type indicated by each atomic instruction in the target queue, and the ordering attribute of each atomic instruction in the target queue, the computation sub-circuit 30 may consecutively perform the modify operation several times, wherein the object on which the initial modify operation is performed may be the raw data, the object on which a non-initial modify operation is performed may be the most recently-cached reference computation result data, and the target computation result data may be generated by the ending modify operation (i.e., the last modify operation). The execution of each atomic instruction in the target queue may be completed by updating the raw data corresponding to the target operation address to the target computation result data, without need to sequentially perform the read operation, the modify operation and the write operation for each atomic instruction, thereby substantially reducing the number of times of execution of the read operation and the number of times of execution of the write operation, and thereby effectively improving the execution efficiency of the atomic instructions.

In some embodiments, the target queue might comprise only one atomic instruction, and the atomic instruction is located at either the head or tail of the target queue, and accordingly, the ordering attribute of the atomic instruction comprises either the head-of-queue attribute or the tail-of-queue attribute. In this case, the computation sub-circuit 30 may perform computation on the raw data directly based on the computation type indicated by the atomic instruction, to generate the target computation result data.

In some optional examples, as shown in FIG. 2, the computation sub-circuit 30 may comprise:
a register 301 configured to cache the reference computation result data;
an operator 303 and a selector 305, the selector 305 being configured to comprise a first mode and a second mode; the selector 305 is configured to enable a first bus between the memory 40 and the operator 303 in the first mode, and the operator 303 is configured to perform computation on the raw data acquired from the first bus; the selector 305 is configured to enable a second bus between the register 301 and the operator 303 in the second mode, and the operator 303 is configured to perform computation on the most recently-cached reference computation result data acquired from the second bus.

Optionally, the register 301 may be a circuit for temporarily storing data, instructions, etc.

Optionally, the operator 303 may be a circuit for performing atomic computation. The operator 303 may be, for example, an Arithmetic Logic Unit (ALU), such that the operator 303 may be used to perform various arithmetic operations and logical operations.

Optionally, the selector 305 may be a multi-input single-output selector. As shown in FIG. 2, the selector 305 may comprise a first input terminal P1, a second input terminal P2 and an output terminal P3; wherein the first input terminal P1 may be electrically connected to the memory 40 via a bus 52; the second input terminal P2 may be electrically connected to the register 301 via a bus 54; the output terminal P3 may be electrically coupled to the operator 303 via a bus 56. The first bus between the memory 40 and the operator 303 may comprise the bus 52 and the bus 56. The second bus between the register 301 and the operator 303 may comprise the bus 54 and the bus 56. In the first mode of the selector 305, the first input terminal P1 and the output terminal P3 may be in a communicated state, and the second input terminal P2 and the output terminal P3 may be in a non-communicated state, so that the first bus between the memory 40 and the operator 303 may be turned on, and the second bus between the register 301 and the operator 303 may not be turned on. In the second mode of the selector 305, the first input terminal P1 and the output terminal P3 may be in a non-communicated state, and the second input terminal P2 and the output terminal P3 may be in a communicated state, so that the first bus between the memory 40 and the operator 303 may not be turned on, and the second bus between the register 301 and the operator 303 may be turned on.

Continuing with the above-mentioned example in which the target queue comprises four atomic instructions, i.e., the atomic instruction D7, the atomic instruction D8, the atomic instruction D9 and the atomic instruction D10, and the computation types indicated by the atomic instruction D7, the atomic instruction D8, the atomic instruction D9 and the atomic instruction D10 are the computation type R1, the computation type R2, the computation type R3 and the computation type R4, respectively, the computation sub-circuit 30 may first set the selector 305 in the first mode, whereupon the first bus between the memory 40 and the operator 303 is turned on, then the raw data in the selector 305 may be sequentially supplied to the operator 303 via the bus 52, the selector 305 and the bus 56 in FIG. 2, and the operator 303 may perform computation on the raw data based on the computation type R1 indicated by the atomic instruction D7 to generate the reference computation result data S1, and cache the reference computation result data S1 into the register 301. Next, the computation sub-circuit 30 may set the selector 305 in the second mode, whereupon the second bus between the register 301 and the operator 303 is turned on, the reference computation result data S1 cached in the register 301 may be sequentially supplied to the operator 303 via the bus 54, the selector 305 and the bus 56, and the operator 303 may perform computation on the reference computation result data S1 based on the computation type R2 indicated by the atomic instruction D8 to generate the reference computation result data S2, and cache the reference computation result data S2 into the register 301, so that the reference computation result data S1 in the register 301 is replaced with the reference computation result data S2, and in addition, indication information indicating the most recent mode (specifically, the second mode) of the selector 305 may be cached in the register 301. Thereafter, since the atomic instruction D9 is not located at the head of the target queue, the computation sub-circuit 30 may still set the selector 305 in the second mode according to the indication information cached in the register 301, whereupon the reference computation result data S2 cached in the register 301 may be sequentially supplied to the operator 303 via the bus 54, the selector 305 and the bus 56, and the operator 303 may perform computation on the reference computation result data S2 based on the computation type R3 indicated by the atomic instruction D9, to generate the reference computation result data S3, and cache the reference computation result data S3 in the register 301 so that the reference computation result data S2 in the register 301 is replaced with the reference computation result data S3. Thereafter, since the atomic instruction D10 is not located at the head of the target queue, the computation sub-circuit 30 may still set the selector 305 in the second mode according to the indication information cached in the register 301, and the reference computation result data S3 cached in the register 301 may be sequentially supplied to the operator 303 via the bus 54, the selector 305 and the bus 56, and the operator 303 may perform computation on the reference computation result data S3 based on the computation type R4 indicated by the atomic instruction D10, to generate the target computation result data. Optionally, the operator 303 may cache the target computation result data into the register 301 so that the reference computation result data S3 in the register 301 is replaced with the target computation result data.

In the embodiment of the present disclosure, the computation sub-circuit 30 may consecutively perform the modify operation several times. By controlling the mode of the selector 305, the computation sub-circuit 30 may, for the initial modify operation, supply the raw data to the operator 303 for computation, and for a non-initial modify operation, supply the most recently-cached reference computation result data to the operator 303 for computation, so that the consecutive execution of the modify operation for several times can be effectively supported by a set of hardware structures.

In some optional examples, the instruction processing sub-circuit 20 may further be configured to determine an atomic instruction to be dequeued from the target queue, and to remove the atomic instruction from the target queue; output the computation type and the ordering attribute corresponding to the atomic instruction; in response to the ordering attribute of the atomic instruction being the head-of-queue attribute, send a first read request for the target operation address to the memory 40, so that the memory 40 outputs the raw data corresponding to the target operation address in response to the first read request;
The computation sub-circuit 30 configured to acquire the raw data in the memory 40 corresponding to the target operation address, the computation type indicated by each atomic instruction in the target queue, and the ordering attribute of each atomic instruction in the target queue, may comprise:
The computation sub-circuit 30 is configured to acquire the raw data output by memory 40, the computation type output by instruction processing sub-circuit 20, and the ordering attribute output by the instruction processing sub-circuit 20.

Optionally, the instruction processing sub-circuit 20 may determine an actual number of atomic instructions currently cached in the first cache space, and based on the determined actual number, determine whether the instruction processing sub-circuit 20 complies with a preset instruction dequeue condition. The preset instruction dequeue condition may include, but not limited to, full occupation of the first cache space, a percentage of the occupation of the first cache space exceeding a preset percentage, etc.

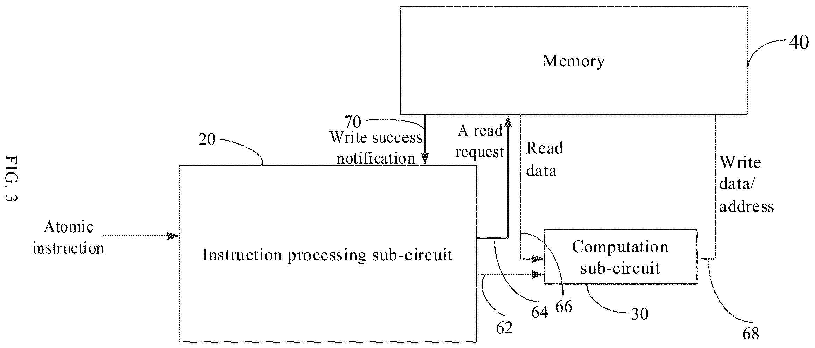

If the instruction processing sub-circuit 20 meets the preset instruction dequeue condition, the instruction processing sub-circuit 20 may determine the atomic instruction to be dequeued from the target queue. The atomic instruction to be dequeued from the target queue may be understood as an atomic instruction to be executed, which may be, for example, an atomic instruction added earliest among the atomic instructions in the target queue. Here, the instruction processing sub-circuit 20 may remove the atomic instruction from the target queue and output the corresponding computation type and the corresponding ordering attribute via a bus (e.g., the bus 62 in FIG. 3) between the instruction processing sub-circuit 20 and the computation sub-circuit 30. As such, the computation sub-circuit 30 may receive the corresponding computation type and the corresponding ordering attribute via the bus 62. Additionally, if the ordering attribute of the atomic instruction is the head-of-queue attribute, the instruction processing sub-circuit 20 may also initiate a first read request for the target operation address to the memory 40 via a bus (e.g., the bus 64 in FIG. 3) between the instruction processing sub-circuit 20 and the memory 40, and the memory 40 may output corresponding read data in response to the first read request, i.e., the read data may serve as the raw data corresponding to the target operation address. The computation sub-circuit 30 may acquire the raw data output by the memory 40 via a bus (e.g., the bus 66 in FIG. 3).

In an embodiment of the present disclosure, by determining the atomic instruction to be dequeued from the target queue, removing the atomic instruction from the target queue, outputting the corresponding computation type and corresponding ordering attribute, and triggering the memory 40 to output the raw data by sending the read request in a case where the ordering attribute of the atomic instruction is the head-of-queue attribute, it is possible to enable to the computation sub-circuit 30 to acquire input data (e.g., the raw data, the computation type, and the ordering attribute) needed for consecutively performing the modify operation several times so that the computation sub-circuit 30 can consecutively perform the modify operation several times accordingly.

In some optional examples, the computation sub-circuit 30 configured to update the raw data corresponding to the target operation address to the target computation result data may comprise:
The computation sub-circuit 30 is configured to send a write request for the target operation address to the memory 40, the write request carrying the target computation result data;
   the memory 40 is configured to update the raw data at the target operation address to the target computation result data in response to the write request; the memory 40 is further configured to output a write success notification in response to the write request;
The instruction processing sub-circuit 20 is configured to count removal states of the atomic instructions removed from the target queue and reception states of the write success notifications; determine the number of instructions being executed by the computation sub-circuit 30 based on the removal states and the reception states;
wherein the computation circuit is configured in a way that the instruction processing sub-circuit 20 allows a value of a maximum number of cached atomic instructions to be greater than or equal to a predetermined maximum value of the number of the instructions being executed by the computation sub-circuit 30.

Optionally, the computation sub-circuit 30 may send the write request for the target operation address to the memory 40 via a bus (e.g., the bus 68 in FIG. 3) between the computation sub-circuit 30 and the memory 40 after having generated the target computation result data. Since the write request carries the target computation result data, after the memory 40 receives the write request via the bus 68, the memory 40 may update the data stored in the address space in the memory 40 corresponding to the target operation address from the raw data to the target computation result data in response to the write request, and, in a case where the update is completed, the memory 40 may also output the write success notification via a bus (e.g., the bus 70 in FIG. 3), so that the write success notification may be transmitted to the instruction processing sub-circuit 20.

Optionally, the instruction processing sub-circuit 20 may count the removal states of atomic instructions removed from the target queue and the reception states of the write success notifications; the removal states of the atomic instructions removed from the target queue for example may be used to characterize the number, removal time etc. of the atomic instructions removed from the target queue; the reception states of the write success notifications may be used, for example, to characterize the number, reception time etc. of the received write success notifications. The instruction processing sub-circuit 20 may determine the number of instructions being executed by the computation sub-circuit 30 based on the removal states and the reception states; the number of instructions being executed by the computation sub-circuit 30 may be understood as the number of the atomic instructions which are being executed by the computation sub-circuit 30 and whose execution has not yet been completed. Here, a counter may be provided in the instruction processing sub-circuit 20, an initial count value of the counter may be zero, the counter may add one to the already-obtained count value every time one atomic instruction is removed from the target queue, and may subtract one from the already-obtained count value every time the instruction processing sub-circuit 20 receives one write success notification. As such, the number of instructions being executed by the computation sub-circuit 30 may be determined based on the current count value of the counter as the removal states and the reception states.

Optionally, the instruction processing sub-circuit 20 may be pre-configured with a predetermined maximum value of the instructions being executed by the computation sub-circuit 30, wherein the predetermine maximum value may be denoted as K which may be, for example, 20, 30, 40, 50, etc. and not enumerated one by one any longer here.

Optionally, the value of the maximum number of atomic instructions allowed to be cached by the instruction processing sub-circuit 20 may be expressed as Nₘₐₓ. Then, if an actual number of atomic instructions cached in the first cache region of the instruction processing sub-circuit 20 is Nₘₐₓ, and the instruction processing sub-circuit 20 may not continue to receive and cache new atomic instructions. The instruction processing sub-circuit 20 may begin to receive and cache new atomic instructions when the actual number of atomic instructions cached in the first cache region of the instruction processing sub-circuit 20 is less than Nₘₐₓ through the collaborative operation of the instruction processing sub-circuit 20 and the computation sub-circuit 30, etc.

In embodiments of the present disclosure, the instruction processing sub-circuit 20 may cache the most recently-received Nₘₐₓ atomic instructions according to a caching rule that atomic instructions corresponding to the same target operation address are cached in the same target queue. The instruction processing sub-circuit 20 may perform removal of atomic instruction, and the computation sub-circuit 30 may perform the modify operation on the removed atomic instructions. Since the computation circuit is configured such that Nₘₐₓ is greater than or equal to K, the instruction processing sub-circuit 20 can adequately supply the computation sub-circuit 30 with atomic instructions for which the modify operation needs to be performed. For any two of the atomic instructions supplied into the computation sub-circuit 30, if the two atomic instructions correspond to the same target operation address, the two atomic instructions are either removed from the same target queue or are spaced apart by at least Nₘₐₓ atomic instructions. If the two atomic instructions are removed from the same target queue, since the computation sub-circuit 30 may consecutively perform the modify operation several times and then perform one write operation for each atomic instruction in the target queue, there will not occur a case that the target computation result data, before being written back, is read again from the target operation address, so that atomicity upon the execution of the atomic instructions can be guaranteed. If the two atomic instructions are spaced apart by at least Nₘₐₓ atomic instructions, since the maximum number of atomic instructions allowed to be cached by the instruction processing sub-circuit 20 has a value of Nₘₐₓ, the instruction processing sub-circuit 20 caches new Nₘₐₓ atomic instructions only in a case where the execution of the existing Nₘₐₓ atomic instruction is completed. This means that the target computation result data obtained based on the Nₘₐₓ atomic instruction whose execution has already been completed has already been written into the memory 40, so that there will not occur the case where the target computation result data, before being written back, is read again from the target operation address, such that the atomicity upon the execution of the atomic instructions can also be guaranteed.

In some optional examples, the instruction processing sub-circuit 20 may also be used to determine a value relationship between a value of an actual number of atomic instructions currently cached by the instruction processing sub-circuit 20 and the value of the number of atomic instructions being executed or the predetermined maximum value, and/or determine a presence attribute of target information for indicating the end of instruction transmission in the atomic instructions currently cached by the instruction processing sub-circuit 20;
The instruction processing sub-circuit 20 further configured to determine the atomic instructions to be dequeued from the target queue may comprise:
The instruction processing sub-circuit 20 is configured to determine the atomic instructions to be dequeued from the target queue in response to determining that the instruction processing sub-circuit 20 meets the preset instruction dequeue condition based on the value relationship and/or presence attribute.

Optionally, the actual number of atomic instructions currently cached by the instruction processing sub-circuit 20 may be obtained by counting the atomic instructions currently cached by instruction processing sub-circuit 20, and the value of the actual number of atomic instructions currently cached by instruction processing sub-circuit 20 may be expressed as N_{actual}. The value of the number of instructions being executed by the computation sub-circuit 30 may be expressed as R. The predetermined maximum value may be expressed as K. The value relationship between the value of the actual number of atomic instructions currently cached by the instruction processing sub-circuit 20 and the value of the number of instructions being executed may be understood as a magnitude relationship between N_{actual} and R, and the value relationship between the value of the actual number of atomic instructions currently cached by the instruction processing sub-circuit 20 and the predetermined maximum value may be understood as a magnitude relationship between N_{actual} and K.

Optionally, the presence attribute of the target information for indicating the end of instruction transmission in the atomic instructions currently cached by the instruction processing sub-circuit 20 may be used to characterize whether the target information is present in the atomic instructions currently cached by the instruction processing sub-circuit 20.

In embodiments of the present disclosure, the instruction processing sub-circuit 20 may determine whether the instruction processing sub-circuit 20 meets the preset instruction dequeue condition based on the value relationship and/or the presence attribute. For example, if the value relationship is used to characterize that N_{actual} is greater than R, or that N_{actual} is greater than K, which indicates that the first cache space of the instruction processing sub-circuit 20 has cached a number of atomic instructions that need to be executed, it may be determined that the instruction processing sub-circuit 20 meets the preset instruction dequeue condition. As another example, if the presence attribute is used to characterize that the target information is present in the atomic instructions currently cached in the instruction processing sub-circuit 20, new atomic instructions will not be added to the target queue before each atomic instruction is removed from the target queue, and it may be determined that the instruction processing sub-circuit 20 meets the preset instruction dequeue condition. As another example, if the value relationship is used to characterize that N_{actual} is greater than K, and the presence attribute is used to characterize that the target information is present in the atomic instructions currently cached in the instruction processing sub-circuit 20, it may be determined that the instruction processing sub-circuit 20 meets the preset instruction dequeue condition. In the case where the instruction processing sub-circuit 20 meets the preset instruction dequeue condition, the instruction processing sub-circuit 20 may determine an atomic instruction to be dequeued from the target queue, for example, determine an atomic instruction that is already present in the target queue and added the earliest, as the atomic instruction to be dequeued.

In embodiments of the present disclosure, by referring to the value relationship and/or presence attribute, it is possible to efficiently and reliably identify the case where the instruction processing sub-circuit 20 meets the preset instruction dequeue condition, to determine the atomic instruction to be dequeued from the target queue on the basis and remove the atomic instruction, output the computation type and the ordering attribute, and on this basis, consecutively perform the modify operation several times for each atomic instruction in the target queue.

In some optional examples, the computation sub-circuit 30 configured to generate target computation result data based on the raw data, the computation type, and the ordering attribute may comprise:
The computation sub-circuit 30 is configured to acquire additional input data that is indicated by each atomic instruction in the target queue and is to participate in the computation; generate the target computation result data based on the raw data, the computation type, the ordering attribute, and the additional input data.

Optionally, for any atomic instruction in the target queue, the atomic instruction may indicate the additional input data that is to participate in the computation. The additional input data may include, but not limited to, an addend for participating in an atomic addition computation, a subtract for participating in an atomic subtraction computation, a multiplier for participating in an atomic multiplication computation, etc.

In some optional implementations of the present disclosure, the instruction processing sub-circuit 20 is configured to output, for each atomic instruction in the target queue, the additional input data carried by the atomic instruction in response to the atomic instruction carrying the additional input data; in response to the atomic instruction carrying an additional address, send a second read request for the additional address to the memory 40, the memory 40 being configured to output the additional input data located at the additional address in the memory 40 in response to the second read request;
The computation sub-circuit 30 being configured to acquire additional input data that is indicated by each atomic instruction in the target queue and is to participate in the computation may comprise:
The computation sub-circuit 30 is configured to acquire the additional input data output by the instruction processing sub-circuit 20 or the memory 40.

Optionally, for any atomic instruction in the target queue, the instruction processing sub-circuit 20 may determine whether the atomic instruction carries the additional input data. If the atomic instruction carries the additional input data, the additional input data may be extracted directly from the atomic instruction and output to the computation sub-circuit 30 via a bus (e.g., the bus 62 shown in FIG. 3). If the atomic instruction does not carry the additional input data, but instead carries the additional address (which indicates an address space in which the additional input data is located), the instruction processing sub-circuit 20 may send the second read request for the additional address to the memory 40, the memory 40 may output corresponding read data in response to the second read request, the read data may serve as the additional input data, and the additional input data may be output to the computation sub-circuit 30 via a bus (e.g., the bus 66 shown in FIG. 3). As such, regardless of whether the atomic instruction carries the additional input data or the additional address, the computation sub-circuit 30 may efficiently and quickly acquire the additional input data for subsequent computation.

Optionally, the computation sub-circuit 30 may generate the target computation result data based on the raw data, the computation type, the ordering attribute and the additional input data. The above example in the preceding text is continued in which the target queue comprises four atomic instructions, i.e., the atomic instruction D7, the atomic instruction D8, the atomic instruction D9 and the atomic instruction D10, and the computation types indicated by the atomic instruction D7, the atomic instruction D8, the atomic instruction D9 and the atomic instruction D10 are the computation type R1, the computation type R2, the computation type R3 and the computation type R4, respectively. It is assumed that the computation type R1 is the atomic addition type, the computation type R2 is the atomic addition type, the computation type R3 is the atomic multiplication type and the computation type R4 is the atomic multiplication type, and that the additional input data corresponding to the atomic instruction D7, the atomic instruction D8, the atomic instruction D9 and the atomic instruction D10 are sequentially additional input data Z1, additional input data Z2, additional input data Z3 and additional input data Z4. The operator 303 may add the additional input data Z1 with the raw data to generate the reference computation result data S1. Next, the operator 303 may multiply the additional input data Z2 with the reference computation result data S1 to generate the reference computation result data S2. Thereafter, the operator 303 may multiply the additional input data Z3 with the reference computation result data S2 to generate the reference computation result data S3. Further, the operator 303 may multiply the additional input data Z4 with the reference computation result data S3 to generate the target computation result data.

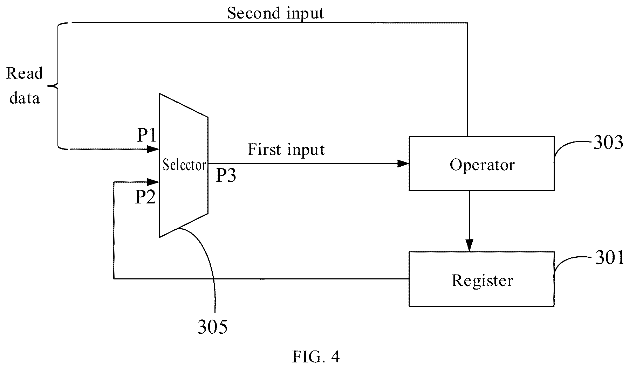

In an optional example, the raw data or reference computation result data transmitted by the selector 305 to the operator 303 may be represented as a first input in FIG. 4, and the additional input data may be represented as a second input in FIG. 4. The operator 303 acquires the first input and the second input respectively via a corresponding bus, and the operator 303 may perform computation on the first input and the second input to finally generate the target computation result data.

In embodiments of the present disclosure, the computation sub-circuit 30 may acquire the additional input data that is indicated by each atomic instruction in the target queue and is to participate in the computation, for use in the generation of the target computation result data. In this way, embodiments of the present disclosure can better support a computation type that requires input in two paths (e.g., the first input and the second input described above).

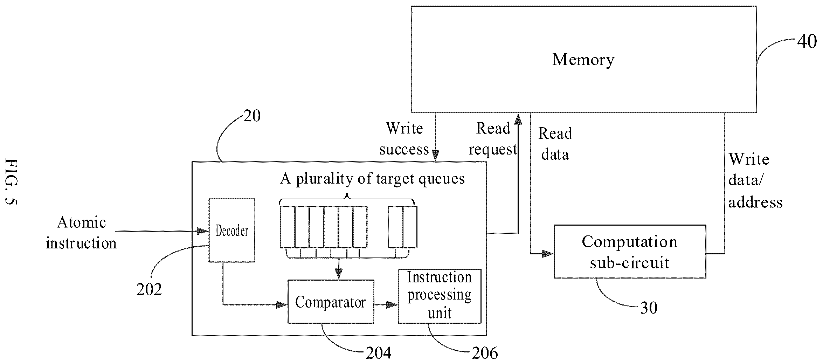

In some optional examples, as shown in FIG. 5, the instruction processing sub-circuit 20 may comprise:
a decoder 202 configured to, in response to each newly received atomic instruction, decode the newly received atomic instruction to obtain an operation address of the newly received atomic instruction;
a comparator 204 configured to compare the operation address of the newly received atomic instruction with the target operation address respectively corresponding to each already-existing target queue to obtain a comparison result;
an instruction processing unit 206 configured to, in response to the comparison result characterizing that the operation address of the newly received atomic instruction matches the target operation address corresponding to the already-existing target queue, cache the newly received atomic instruction in the already-existing target queue; in response to the comparison result characterizing that the operation address of the newly received atomic instruction does not match the target operation address respectively corresponding to each already-existing target queue, create a new target queue and cache the newly received atomic instruction in the new target queue.

Optionally, the decoder 202 may be a hardware unit for decoding the atomic instructions. The comparator 204 may be hardware for comparing different inputs. The instruction processing unit 206 may be hardware for performing a corresponding processing operation with reference to the comparison result of the comparator 204. The comparator 204 may be electrically connected to the decoder 202, and the instruction processing unit 206 may be electrically connected to the comparator 204.

In embodiments of the present disclosure, each time an atomic instruction is newly received by the instruction processing sub-circuit 20, the decoder 202 may decode the newly received atomic instruction to separate the operation address from the newly received atomic instruction, i.e., obtain the operation address of the newly received atomic instruction. The decoder 202 may send the operation address of the newly received atomic instruction to the comparator 204. The comparator 204 may also acquire the target operation address respectively corresponding to each already-existing target queue. The comparator 204 may compare the operation address of the newly received atomic instruction with the target operation address respectively corresponding to each already-existing target queue to obtain a comparison result; wherein the comparison result is used for characterizing whether the operation address of the newly received atomic instruction is the same as the target operation address corresponding to the already-existing target queue. If the comparison result characterizes that the operation address of the newly received atomic instruction is the same as the target operation address corresponding to the already-existing target queue, which indicates that the operation address of the newly received atomic instruction matches the target operation address corresponding to the already-existing target queue, the newly received atomic instruction may be added to the already-existing target queue. In this case, the newly received atomic instruction may specifically be placed at the tail of the target queue. If the comparison result characterizes that the operation address of the newly received atomic instruction is not the same as the target operation address corresponding to any already-existing target queue, which indicates that the operation address of the newly received atomic instruction does not match the target operation address respectively corresponding to each already-existing target queue, the instruction processing unit 206 may create a new target queue in the first cache space, and the newly received atomic instruction may specifically be placed at the head of the new target queue. In this way, when each atomic instruction in the target queue is executed subsequently, the atomic instruction which enters the target queue early will be removed and executed early, and the atomic instruction which enters the target queue later will be removed and executed later, which is beneficial to ensure the correctness of the execution order of these atomic instructions.

In the embodiments of the present disclosure, through the collaborative operation of the decoder 202, the comparator 204 and the instruction processing unit 206, the caching of the atomic instructions may be performed according to the caching rule that the atomic instructions with the same operation address are cached in the same target queue. On this basis, the modify operation may be consecutively performed several times subsequently for each atomic instruction in the target queue, so that the execution of each atomic instruction in the target queue may be completed based on one read operation, several modify operations and one write operation, thereby effectively improving the execution efficiency of the atomic instructions.

In some optional examples, referring to FIG. 5, if it is identified that the instruction processing sub-circuit 20 meets the preset instruction dequeue condition in conjunction with the value relationship and presence attribute stated above, the instruction processing sub-circuit 20 may, starting with the oldest target queue, send the read request to the memory 40 in the order from head-of-queue element to tail-of-queue element, and the corresponding atomic instructions may be dequeued after successful sending. After each read request has been sent, the next read request will be sent if the instruction processing sub-circuit 20 still meets the preset dequeue condition. While the read request is being sent, the computation type and corresponding ordering attribute indicated by the corresponding atomic instruction may also be transmitted to the computation sub-circuit 30. The computation sub-circuit 30 may acquire read data (which may comprise the first input and the second input described above) output by memory 40 in response to the read request. The computation sub-circuit 30 may consecutively perform the computation multiple times based on the first input, the computation type, the ordering attribute and the second input, to generate the target computation result data. Finally, the computation sub-circuit 30 may write the target computation result data back to the memory 40.

In summary, in the embodiments of the present disclosure, the atomic instructions are cached according to the cache rule that atomic instructions corresponding to the same target operation address are cached in the same target queue, so that the execution may be consecutively performed for a plurality of atomic instructions with the same target operation address by only accessing the memory 40 twice (one read operation and one write operation), thereby substantially improving the execution efficiency of the atomic instructions. Additionally, in embodiments of the present disclosure, the atomicity upon the execution of atomic instructions is advantageously ensured by configuring the computation circuit in a way that the instruction processing sub-circuit 20 allows the value of the maximum number of cached atomic instructions to be greater than or equal to the predetermined maximum value of the number of instructions being executed by the computation sub-circuit 30.

### Exemplary Methods

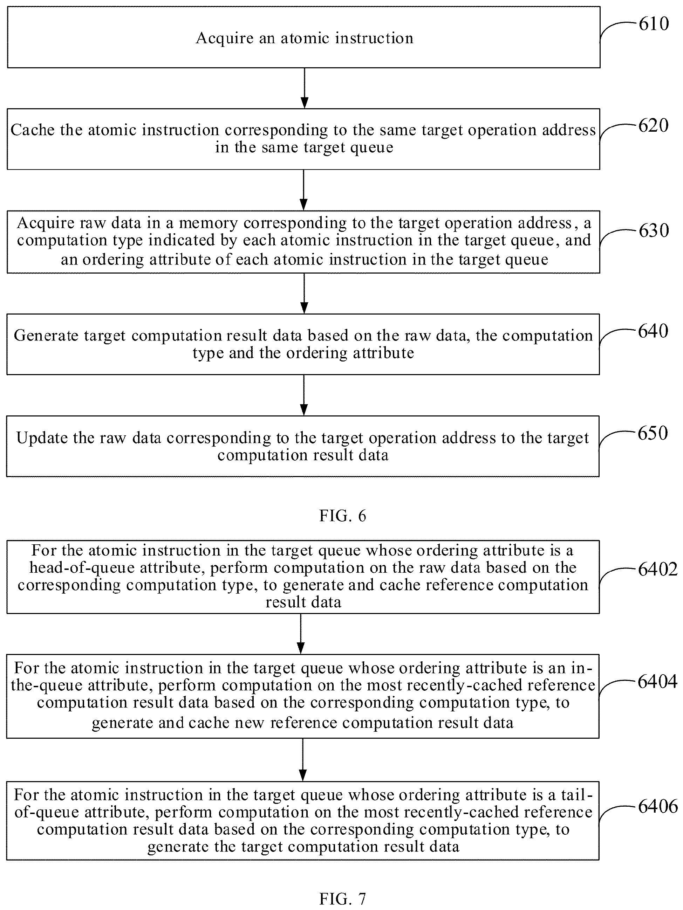

FIG. 6 is a flow chart of a data processing method according to some exemplary embodiments of the present disclosure. The method shown in FIG. 6 may comprise:
Step 610: acquiring an atomic instruction;
Step 620: caching the atomic instruction corresponding to the same target operation address in the same target queue;
Step 630: acquiring raw data in a memory corresponding to the target operation address, a computation type indicated by each atomic instruction in the target queue, and an ordering attribute of each atomic instruction in the target queue;
Step 640: generating target computation result data based on the raw data, the computation type and the ordering attribute;
Step 650: updating the raw data corresponding to the target operation address to the target computation result data.

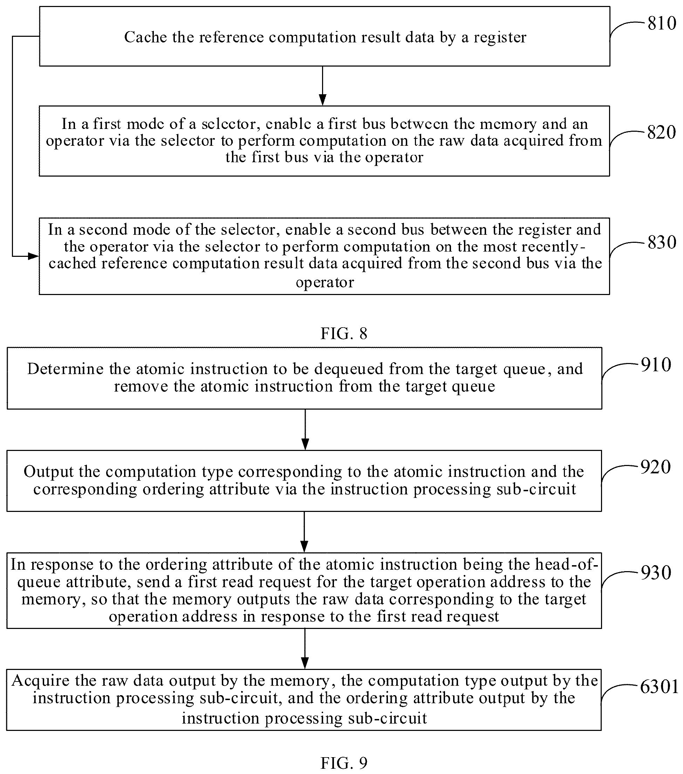

In some optional examples, as shown in FIG. 7, step 640 may comprise:
Step 6402: for the atomic instruction in the target queue whose ordering attribute is a head-of-queue attribute, performing computation on the raw data based on the corresponding computation type, to generate and cache reference computation result data;
Step 6404: for the atomic instruction in the target queue whose ordering attribute is an in-the-queue attribute, performing computation on the most recently-cached reference computation result data based on the corresponding computation type, to generate and cache new reference computation result data;
Step 6406: for the atomic instruction in the target queue whose ordering attribute is a tail-of-queue attribute, performing computation on the most recently-cached reference computation result data based on the corresponding computation type, to generate the target computation result data.
In some optional examples, as shown in FIG. 8, the method according to embodiments of the present disclosure may further comprise:
Step 810: caching the reference computation result data by a register;
Step 820: in a first mode of a selector, enabling on a first bus between the memory and an operator via the selector to perform computation on the raw data acquired from the first bus via the operator;
Step 830: in a second mode of the selector, enabling on a second bus between the register and the operator via the selector to perform computation on the most recently-cached reference computation result data acquired from the second bus via the operator.

In some optional examples, as shown in FIG. 9, the method according to embodiments of the present disclosure may further comprise:
Step 910: determining the atomic instruction to be dequeued from the target queue, and removing the atomic instruction from the target queue;
Step 920: outputting the computation type corresponding to the atomic instruction and the corresponding ordering attribute via the instruction processing sub-circuit;
Step 930: in response to the ordering attribute of the atomic instruction being the head-of-queue attribute, sending a first read request for the target operation address to the memory, so that the memory outputs the raw data corresponding to the target operation address in response to the first read request;
Step 630 may comprise:
Step 6301: acquiring the raw data output by the memory, the computation type output by the instruction processing sub-circuit, and the ordering attribute output by the instruction processing sub-circuit.

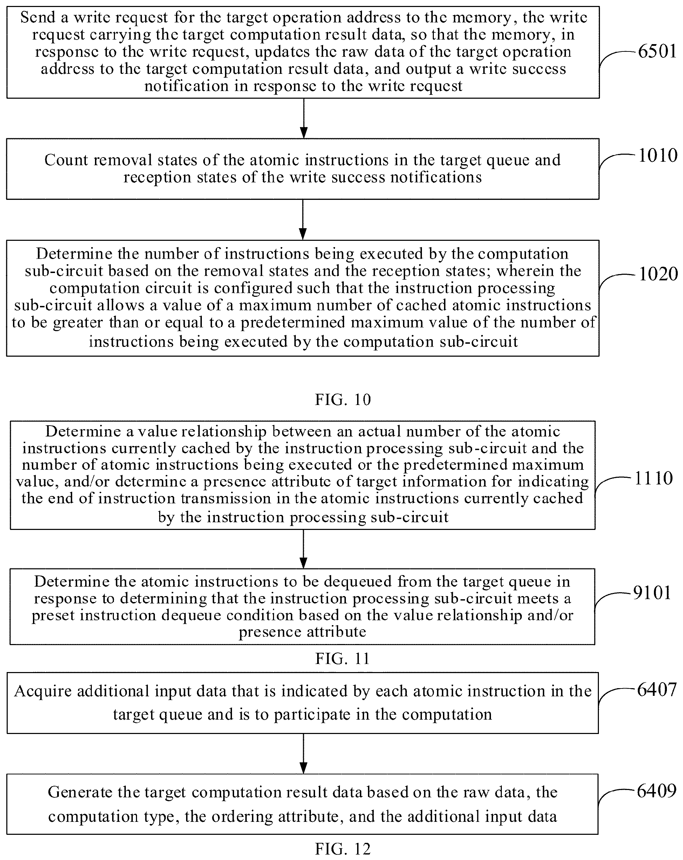

In some optional examples, as shown in FIG. 10, step 650 may comprise:
Step 6501: sending a write request for the target operation address to the memory, the write request carrying the target computation result data, so that the memory, in response to the write request, updates the raw data of the target operation address to the target computation result data, and outputs a write success notification in response to the write request;
As shown in FIG. 10, the method according to embodiments of the present disclosure may further comprise:
   Step 1010: counting removal states of the atomic instructions in the target queue and reception states of the write success notifications;
   Step 1020: determining the number of instructions being executed by the computation sub-circuit based on the removal states and the reception states; wherein the computation circuit is configured such that the instruction processing sub-circuit allows a value of a maximum number of cached atomic instructions to be greater than or equal to a predetermined maximum value of the number of instructions being executed by the computation sub-circuit.

In some optional examples, as shown in FIG. 11, the method according to embodiments of the present disclosure may further comprise:
Step 1110: determining a value relationship between an actual number of the atomic instructions currently cached by the instruction processing sub-circuit and the number of atomic instructions being executed or the predetermined maximum value, and/or determining a presence attribute of target information for indicating the end of instruction transmission in the atomic instructions currently cached by the instruction processing sub-circuit;
Step 910 may comprise:
Step 9101: determining the atomic instructions to be dequeued from the target queue in response to determining that the instruction processing sub-circuit meets a preset instruction dequeue condition based on the value relationship and/or presence attribute.

In some optional examples, as shown in FIG. 12, step 640 may comprise:
Step 6407: acquiring additional input data that is indicated by each atomic instruction in the target queue and is to participate in the computation;
Step 6409: generating the target computation result data based on the raw data, the computation type, the ordering attribute, and the additional input data.

In some optional examples, step 6407 may comprise:
for each atomic instruction in the target queue, outputting, by the instruction processing sub-circuit, additional input data carried by the atomic instruction in response to the atomic instruction carrying the additional input data; in response to the atomic instruction carrying an additional address, sending a second read request for the additional address to the memory, so that the memory outputs the additional input data in the memory located at the additional address in response to the second read request;
Step 6407 may comprise:
   acquiring the additional input data output by the instruction processing sub-circuit or the memory.

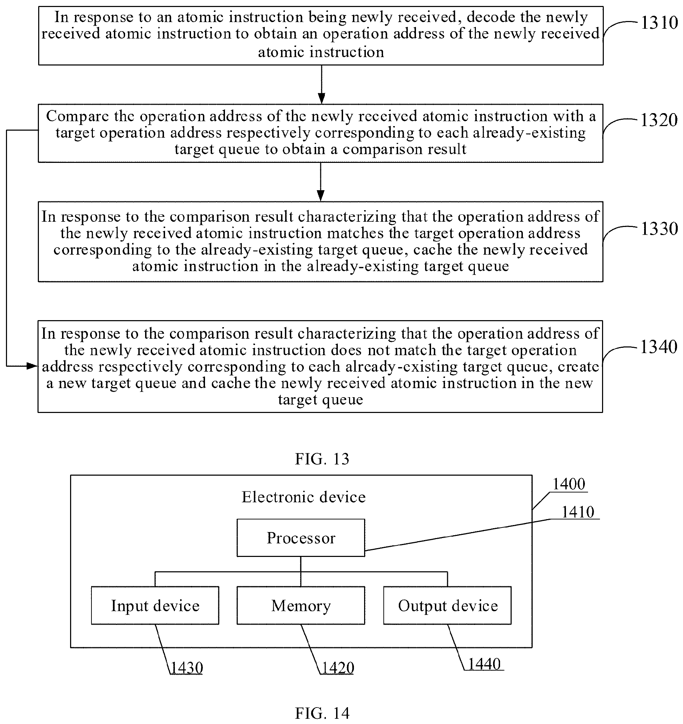

In some optional examples, as shown in FIG. 13, the method according to embodiments of the present disclosure may further comprise:
Step 1310: in response to an atomic instruction being newly received, decoding the newly received atomic instruction to obtain an operation address of the newly received atomic instruction;
Step 1320: comparing the operation address of the newly received atomic instruction with a target operation address respectively corresponding to each already-existing target queue to obtain a comparison result;
Step 1330: in response to the comparison result characterizing that the operation address of the newly received atomic instruction matches the target operation address corresponding to the already-existing target queue, caching the newly received atomic instruction in the already-existing target queue;
Step 1340: in response to the comparison result characterizing that the operation address of the newly received atomic instruction does not match the target operation address respectively corresponding to each already-existing target queue, creating a new target queue and caching the newly received atomic instruction in the new target queue.

In the method of the present disclosure, the various optional embodiments, optional implementations and optional examples disclosed in the above part Exemplary System may be flexibly selected and combined as needed, to achieve corresponding functions and effects, and will not be enumerated one by one in the present disclosure.

Advantageous effects corresponding to exemplary embodiments of the method can be found from the corresponding advantageous effects of the above part Exemplary System and will not be described in detail any more here.

### Exemplary Electronic Device

FIG. 14 illustrates a block diagram of an electronic device 1400 including one or more processors 1410 and a memory 1420 according to an embodiment of the present disclosure.

The processor 1410 may be a Central Processing Unit (CPU) or another form of processing unit having a data processing capability and/or an instruction execution capability, and may control other components in the electronic device 1400 to perform a desired function.

The memory 1420 may include one or more computer program products. The computer program product may include various forms of computer-readable storage media, such as a volatile memory and/or a non-volatile memory. The volatile memory may include, for example, a Random Access Memory (RAM) and/or a cache. The non-volatile memory may include, for example, a Read-Only Memory (ROM), a hard disk, a flash memory or the like. The computer-readable storage medium may store one or more computer program instructions. The processor 1410 may run the computer program instructions, to implement the method in the foregoing embodiments of the present disclosure and/or other desired functions.

In an example, the electronic device 1400 may further include: an input device 1430 and an output device 1440. The components are interconnected through a bus system and/or other forms of connection mechanisms (not shown).

The input device 1430 may further include for example a keyboard, a mouse or the like.

The output device 1440 may output various information to the outside, and may include, for example, a display, a speaker, a printer, a communication network, and a remote output device connected to the communication network.

Certainly, for simplicity, only some components in the electronic device 1400 that are related to the present disclosure are shown in FIG. 14, and components such as a bus and an input/output interface are omitted. Besides, the electronic device 1400 may further include any other appropriate components depending on specific applications.

### Exemplary Computer Program Product and Computer Readable Storage Medium

In addition to the foregoing methods and devices, an embodiment of the present disclosure may be a computer program product, including computer program instructions. The computer program instructions, when executed by a processor, cause the processor to perform the steps in the method according to the embodiments of the present disclosure described in the foregoing part "Exemplary Method" of this specification.

The computer program product may be used to write, in any combination of one or more programming languages, program code for performing an operation in this embodiment of the present disclosure. The programming languages include object-oriented programming languages, such as Java and C++, and conventional procedural programming languages, such as "C" language or similar programming languages. The program code may be executed entirely on a user computing device, partly on user equipment, as a standalone software package, partly on a user computing device and partly on a remote computing device, or entirely on a remote computing device or a server.

In addition, the embodiment of the present disclosure may alternatively be a computer-readable storage medium, storing computer program instructions. The computer program instructions, when executed by a processor, cause the processor to perform the steps in the method according to the embodiments of the present disclosure described in the foregoing part "Exemplary Method" of this specification.

The computer-readable storage medium may be any combination of one or more readable mediums. The readable medium may be a readable signal medium or a readable storage medium. The readable storage medium may include, for example, but is not limited to electrical, magnetic, optical, electromagnetic, infrared, or semiconductor systems, apparatuses, or devices, or any combination thereof. More specific examples (non-exhaustive list) of the readable storage medium include: an electrical connection with one or more conducting wires, a portable disk, a hard disk, a RAM, a ROM, an Erasable Programmable Read-Only Memory (EPROM or flash memory), an optical fiber, a portable Compact Disc Read-Only Memory (CD-ROM), an optical memory device, a magnetic memory device, or any suitable combination thereof.

The basic principles of the present disclosure have been described above with reference to specific embodiments. However, it should be noted that the benefits, advantages, effects, and the like mentioned in the present disclosure are only examples rather than limitations, and these benefits, advantages, effects, and the like should not be considered to be necessary for the embodiments of the present disclosure. Moreover, the specific details disclosed above are for exemplary purposes and ease of understanding only, but not for limitation, and the above details do not limit the present disclosure to be implemented by using the specific details described above.

Those skilled in the art can make various variations and modifications to the present disclosure without departing from scope of the present disclosure. As such, if these variations and modifications to the present disclosure fall within the scope of claims of the present disclosure and equivalent technologies, the present disclosure is also intended to include these variations and modifications.

## Claims

1. A computation circuit, comprising:
an instruction processing sub-circuit configured to acquire (610) an atomic instruction, and cache (620) the atomic instruction corresponding to the same target operation address in the same target queue;
a computation sub-circuit configured to acquire (630) raw data in a memory corresponding to the target operation address, a computation type indicated by each atomic instruction in the target queue, and an ordering attribute of each atomic instruction in the target queue; generate (640) target computation result data based on the raw data, the computation type and the ordering attribute; and update (650) the raw data corresponding to the target operation address to the target computation result data.

2. The computation circuit according to claim 1, wherein the computation sub-circuit being configured to generate target computation result data based on the raw data, the computation type and the ordering attribute comprises:
the computation sub-circuit is configured to, for the atomic instruction in the target queue whose ordering attribute is a head-of-queue attribute, perform (6402) computation on the raw data based on the corresponding computation type, to generate and cache reference computation result data;
the computation sub-circuit is configured to, for the atomic instruction in the target queue whose ordering attribute is an in-the-queue attribute, perform (6404) computation on the most recently-cached reference computation result data based on the corresponding computation type, to generate and cache new reference computation result data; and
the computation sub-circuit is configured to, for the atomic instruction in the target queue whose ordering attribute is a tail-of-queue attribute, perform (6406) computation on the most recently-cached reference computation result data based on the corresponding computation type, to generate the target computation result data.

3. The computation circuit according to claim 2, wherein the computation sub-circuit comprises:
a register configured to cache (810) the reference computation result data;
an operator and a selector, the selector being configured to comprise a first mode and a second mode; the selector is configured to enable (820) a first bus between the memory and the operator in the first mode, and the operator is configured to perform computation on the raw data acquired from the first bus; the selector is configured to enable (830) a second bus between the register and the operator in the second mode, and the operator is configured to perform computation on the most recently-cached reference computation result data acquired from the second bus.

4. The computation circuit according to any one of the preceding claims, wherein,
the instruction processing sub-circuit is further configured to determine (910) the atomic instruction to be dequeued from the target queue, and remove the atomic instruction from the target queue; output (920) the computation type corresponding to the atomic instruction and the corresponding ordering attribute; in response to the ordering attribute of the atomic instruction being the head-of-queue attribute, send (930) a first read request for the target operation address to the memory, so that the memory outputs the raw data corresponding to the target operation address in response to the first read request;
the computation sub-circuit configured to acquire raw data in a memory corresponding to the target operation address, a computation type indicated by each atomic instruction in the target queue, and an ordering attribute of each atomic instruction in the target queue comprises:
the computation sub-circuit is configured to acquire (940) the raw data output by the memory, the computation type output by the instruction processing sub-circuit, and the ordering attribute output by the instruction processing sub-circuit.

5. The computation circuit according to claim 4, wherein
the computation sub-circuit configured to update the raw data corresponding to the target operation address to the target computation result data comprises:
the computation sub-circuit is configured to send a write request for the target operation address to the memory, the write request carrying the target computation result data;
the memory is configured to, in response to the write request, update the raw data of the target operation address to the target computation result data; the memory is further configured to output a write success notification in response to the write request;
the instruction processing sub-circuit is configured to count removal states of the atomic instructions in the target queue and reception states of the write success notifications; determine the number of instructions being executed by the computation sub-circuit based on the removal states and the reception states; and
wherein the computation circuit is configured such that the instruction processing sub-circuit allows a value of a maximum number of cached atomic instructions to be greater than or equal to a predetermined maximum value of the number of instructions being executed by the computation sub-circuit.

6. The computation circuit according to claim 5, wherein,
the instruction processing sub-circuit is further configured to determine (1110) a value relationship between an actual number of the atomic instructions currently cached by the instruction processing sub-circuit and the number of atomic instructions being executed or the predetermined maximum value, and/or determine a presence attribute of target information for indicating the end of instruction transmission in the atomic instructions currently cached by the instruction processing sub-circuit;
the instruction processing sub-circuit further configured to determine the atomic instruction to be dequeued from the target queue comprises:
the instruction processing sub-circuit is configured to determine (9101) the atomic instructions to be dequeued from the target queue in response to determining that the instruction processing sub-circuit meets a preset instruction dequeue condition based on the value relationship and/or the presence attribute.

7. The computation circuit according to any one of the preceding claims, wherein the computation sub-circuit configured to generate target computation result data based on the raw data, the computation type and the ordering attribute comprises:
the computation sub-circuit is configured to acquire (6407) additional input data that is indicated by each atomic instruction in the target queue and is to participate in the computation; generate (6409) the target computation result data based on the raw data, the computation type, the ordering attribute, and the additional input data.

8. The computation circuit according to claim 7, wherein
the instruction processing sub-circuit is configured to, for each atomic instruction in the target queue, output additional input data carried by the atomic instruction in response to the atomic instruction carrying the additional input data; in response to the atomic instruction carrying an additional address, send a second read request for the additional address to the memory, the memory being configured to output the additional input data in the memory located at the additional address in response to the second read request;
the computation sub-circuit configured to acquire additional input data that is indicated by each atomic instruction in the target queue and is to participate in the computation comprises:
the computation sub-circuit is configured to acquire the additional input data output by the instruction processing sub-circuit or the memory.

9. The computation circuit according to any of claims 1-8, wherein the instruction processing sub-circuit comprises:
a decoder configured to, in response to each newly received atomic instruction, decode (1310) the newly received atomic instruction to obtain an operation address of the newly received atomic instruction;
a comparator configured to compare (1320) the operation address of the newly received atomic instruction with the target operation address respectively corresponding to each already-existing target queue to obtain a comparison result;
an instruction processing unit configured to, in response to the comparison result characterizing that the operation address of the newly received atomic instruction matches the target operation address corresponding to the already-existing target queue, cache (1330) the newly received atomic instruction in the already-existing target queue; in response to the comparison result characterizing that the operation address of the newly received atomic instruction does not match the target operation address respectively corresponding to each already-existing target queue, create (1340) a new target queue and cache the newly received atomic instruction in the new target queue.

10. A data processing method, comprising:
acquiring (610) an atomic instruction;
caching (620) the atomic instruction corresponding to the same target operation address in the same target queue;
acquiring (630) raw data in a memory corresponding to the target operation address, a computation type indicated by each atomic instruction in the target queue, and an ordering attribute of each atomic instruction in the target queue;
generating (640) target computation result data based on the raw data, the computation type and the ordering attribute; and
updating (650) the raw data corresponding to the target operation address to the target computation result data.

11. The data processing method according to claim 10, wherein generating the target computation result data based on the raw data, the computation type and the ordering attribute comprises:
for the atomic instruction in the target queue whose ordering attribute is a head-of-queue attribute, performing (6402) computation on the raw data based on the corresponding computation type, to generate and cache reference computation result data;
for the atomic instruction in the target queue whose ordering attribute is an in-the-queue attribute, performing (6404) computation on the most recently-cached reference computation result data based on the corresponding computation type, to generate and cache new reference computation result data; and
for the atomic instruction in the target queue whose ordering attribute is a tail-of-queue attribute, performing (6406) computation on the most recently-cached reference computation result data based on the corresponding computation type, to generate the target computation result data.

12. The data processing method according to claim 10 or 11, further comprising:
determining (910) the atomic instruction to be dequeued from the target queue;
removing the atomic instruction from the target queue;
outputting (920) the computation type corresponding to the atomic instruction and the corresponding ordering attribute; and
in response to the ordering attribute of the atomic instruction being the head-of-queue attribute, sending (930) a first read request for the target operation address to the memory, so that the memory outputs the raw data corresponding to the target operation address in response to the first read request; and
wherein acquiring raw data in the memory corresponding to the target operation address, the computation type indicated by each atomic instruction in the target queue, and the ordering attribute of each atomic instruction in the target queue comprises:
acquiring (940) the raw data output by the memory, the computation type output by the instruction processing sub-circuit, and the ordering attribute output by the instruction processing sub-circuit.

13. The data processing method according to claim 12, wherein updating the raw data corresponding to the target operation address to the target computation result data comprises:
sending a write request for the target operation address to the memory, the write request carrying the target computation result data;
in response to the write request, updating the raw data of the target operation address to the target computation result data;
outputting a write success notification in response to the write request;
counting removal states of the atomic instructions in the target queue and reception states of the write success notifications;
determining the number of instructions being executed by the computation sub-circuit based on the removal states and the reception states; and
wherein a value of a maximum number of cached atomic instructions is allowed to be greater than or equal to a predetermined maximum value of the number of instructions being executed by the computation sub-circuit.

14. A computer readable storage medium storing a computer program which is executed by a processor to perform the data processing method according to any of claims 10-13.

15. An electronic device (1400), comprising:
a processor (1410);
a memory (1420) for storing instructions executable by the processor;
the processor is configured to read the executable instructions from the memory and execute the instructions to implement the data processing method according to any of claims 10-13.
